(19) Europäisches Patentamt
European Patent Office
Office européen des brevets

(11) Publication number: 0 313 249
A1

# (12) EUROPEAN PATENT APPLICATION

(21) Application number: 88309483.1

(51) Int. Cl.4: H01L 29/06

(22) Date of filing: 10.10.88

(30) Priority: 19.10.87 US 110153

(43) Date of publication of application:
26.04.89 Bulletin 89/17

(84) Designated Contracting States:
DE ES GB NL

(71) Applicant: AMERICAN TELEPHONE AND TELEGRAPH COMPANY
550 Madison Avenue
New York, NY 10022(US)

(72) Inventor: Knolle, William Reynold
5574 Princeton Road
Macungie Pennsylvania 18062(US)
Inventor: Osenbach, John William
6 Matthew Drive
Sinking Springs Pennsylvania 19608(US)

(74) Representative: Watts, Christopher Malcolm Kelway et al
AT&T (UK) LTD. AT&T Intellectual Property Division 5 Mornington Road
Woodford Green Essex IG8 OTU(GB)

## (54) Resistive field shields for high voltage devices.

(57) A high voltage silicon device with a resistive field shield (26) comprising semi-insulating silicon nitride (sin-SiN). The N/Si ratio is controlled to provide the resistive field shield with the desired conductivity. This resistive field shield material may also serve as an outer protection layer for the device.

FIG. 1

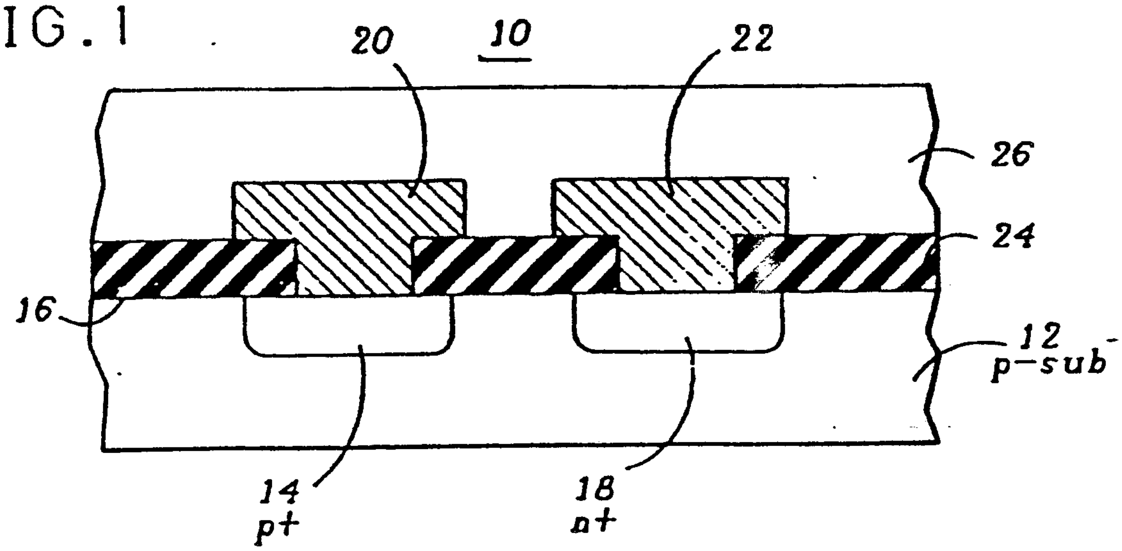


EP 0 313 249 A1

# RESISTIVE FIELD SHIELDS FOR HIGH VOLTAGE DEVICES

## Background of the Invention

### 1. Technical Field

The present invention relates to high voltage devices with resistive field shields.

### 2. Description of the Prior Art

The breakdown voltage and/or leakage current of high voltage discrete devices and integrated circuits will be degraded by the presence of charge (usually ionic) on the top surface of the outermost passivation layer. These mobile charges may also form a surface channel which can effectively create a shunt resistor between the emitter-base, emitter-collector, or collector-base electrodes. In the presence of an electric field, high temperature, and/or moisture, these surface ions can redistribute and create large extrinsic potentials on the surface of the chip. Additionally, cracks or pinholes in the top passivation layer will allow charge to leak up into or on top of this layer and spread out from the point of origination. If the potential generated by this leakage charge is different from that of the silicon below it, field crowding results, leading to a degradation of both the breakdown voltage and leakage current of the high voltage device.

A technique for limiting this effect is to shield the surface of the device from the effects of the charge by using a resistive field shield which contacts the surface and makes electrical contact to conductors on the surface. A semi-insulating polysilicon (SIPOS) layer may be used as such a shield. A description of this type of field shield may be found in the article entitled "Characterisation and modelling of SIPOS on silicon high-voltage devices" by J. N. Sandoe et al. appearing in *IEE Proceedings*, Vol. 132, Pt. 1, No. 6, December 1985 at pp. 281-3. One problem created by the use of a SIPOS shield layer is that it introduces leakage which may be greater than is acceptable in some applications (extreme high voltage applications, for example).

One technique for increasing the effectiveness of a SIPOS field shield is disclosed in U.S. Patent 4,580,156 issued to R. B. Comizzoli on April 1, 1986. A segmented SIPOS layer is used by Comizzoli as a resistive field shield, where the segmentation of the layer significantly increases the resistance thereof and thereby limits the leakage generated by the layer. The segmentation, however, adds to the complexity of the device fabrication process.

As a material, SIPOS has further problems which limit its usefulness as a passivation material. Firstly, SIPOS is extremely reactive in a humid environment, experiencing drastic conductivity changes (both increases and decreases) which are neither well-controlled nor well-understood. In particular, when SIPOS is in contact with aluminium metallization, the aluminium will penetrate the surface, forming $Al_2O_3$ at the interface. Thus, SIPOS is essentially limited to utilization with devices encased in hermetic packages, resulting in increasing the cost (and perhaps size) of the final packaged device. Additionally, when SIPOS is used with tri-level metal contacts (Ti-Pt-Au), the gold will migrate through the contact, forming various eutectic bonds with the SIPOS. Again, these bonds will seriously degrade the performance of the device.

Thus, a need remains in the prior art for a resistive field shield for high voltage devices which overcomes these and other limitations associated with SIPOS resistive field shields.

## Summary of the Invention

The present invention as claimed provides a device with a semi-insulating silicon nitride (sin-SiN) resistive field shield.

## Brief Description of the Drawing

Referring now to the drawings,

FIGs. 1-5 illustrate, in cross-sectional views, various exemplary high voltage devices formed with a semi-insulating silicon nitride (sin-SiN) resistive field shield of the present invention; and

FIG. 6 is a graph illustrating the relationship between conductivity of the sin-SiN resistive field shield as a function of its N/Si ratio.

## Detailed Description

An exemplary high voltage device 10 formed with the semi-insulating silicon nitride (sin-SiN) resistive field shield layer of the present invention is illustrated in cross-sectional form in FIG. 1. Device 10 comprises a semiconductor substrate 12 of a first conductivity type, shown as p-type in FIG. 1. A first diffusion region 14 of the same conductivity type, but higher dopant concentration, is formed through surface 16 of substrate 12. A second diffusion region 18, of the opposite conductivity type, is also formed through surface 16, at a location spaced-apart from first diffusion region 14. A pair of metal electrodes 20,22 are formed to contact first and second diffusions 14 and 18, respectively. A dielectric layer 24 is disposed across surface 16 of substrate 12 to provide electrical isolation between electrodes 20 and 22.

In accordance with the present invention, the structure is then covered with a layer of semi-insulating silicon nitride (sin-SiN) which forms the resistive field shield 26 of the high voltage device. As described above, resistive field shield 26 functions to isolate any charge in or on the device surface, shielding the active device regions formed below. The field of the ionic charge is essentially terminated in the resistive layer and does not reach or affect the silicon below.

In some instances, it may not be desirable to utilize the sin-SiN material as the outer protection layer of the device. Also, the use of a relatively thick sin-SiN layer, similar to layer 26 of FIG. 1, may be disadvantageous in some circumstances. An alternative high voltage structure 30 utilizing the sin-SiN passivation layer of the present invention is illustrated in FIG. 2. The identical active device is illustrated for the sake of comparison, namely, a p-type substrate 12 including p+ diffusion region 14 and n+ diffusion region 18, both formed through top major surface 16 of substrate 12. Metal contacts 20 and 22 to regions 14 and 18, respectively, are insulated by dielectric layer 24. In this particular embodiment, a sin-SiN passivation layer 32 is formed over dielectric layer 24, layer 32 being patterned simultaneously with layer 24 to expose regions 14 and 18 for subsequent metallization. An outer protective layer 34 of a low temperature dielectric is utilized with this particular device structure. FIG. 3 illustrates a slight modification of device 30 of FIG. 2. Here, a high voltage device 40 utilizes a relatively thin sin-SiN passivation layer 42 which is directly disposed over top major surface 16 of substrate 12. Insulation between active device regions is provided by a dielectric layer 44 which is formed over sin-SiN layer 52. As with device 30 of FIG. 2, the outer protection layer 46 comprises SINCAP.

FIG. 4 illustrates yet another device structure which can be formed with the sin-SiN layer of the present invention. Here, a high voltage device 50 utilizes a conventional dielectric layer 24 over surface 16 of substrate 12. A first layer 52 of SiNCAP is disposed to cover the exposed portions of dielectric layer 24, as well as contacts 20 and 22. A relatively thick sin-SiN passivation layer 54 is then deposited to completely cover layer 42. Yet another alternative device structure 60 which may be formed utilizing the sin-SiN passivation layer of the present invention is illustrated in FIG. 5. As shown, the dielectric layer of the other arrangements is replaced with a tri-level structure, including a first dielectric layer 62, a layer 64 of sin-SiN, and a final dielectric layer 66, disposed to cover the sin-SiN passivation layer. This tri-level structure is then etched to expose regions 14 and 18 for contact to metallizations 20 and 22, respectively. An outer layer 68 of SiNCAP may then be utilized as the final layer of this particular structure.

Any suitable deposition technique (e.g., LPCVD, MOCVD, plasma) may be used to form the novel sin-SiN passivation layer. It has been found that regardless of the deposition technique, the control of the N/Si ratio in the sin-SiN layer will affect its conductivity. This relationship between the N/Si ratio and conductivity $\sigma$ is illustrated in FIG. 6 for two exemplary sin-SiN deposition processes. The first process, a plasma deposition process, utilizes the gases $SiH_4$ and $NH_3$. The plot of its conductivity as a function of N/Si ratio is illustrated by the letter "P" in FIG. 6. As seen, this particular plasma deposition process yields a film with the greatest conductivity (approximately $1 \times 10^{-7}$ $(\Omega\text{-cm})^{-1}$ with a N/Si ratio of about 1/5. The conductivity then decreases in a somewhat linear fashion as the concentration of N is increased, until a conductivity of about $1 \times 10^{-16}$ is reached for a 1/1 N/Si ratio. The conductivity as a function of N/Si is also illustrated in FIG. 6 for an exemplary LPCVD process with utilizes $SiCl_2H_2$ and $NH_3$ to form the passivation layer. The plot of this conductivity as a function of N/Si is denoted by the letter "L" in FIG. 6. As can be seen, this curve roughly follows the contour of the P plot for the plasma deposition process, although yielding somewhat lower conductivity values for like N/Si ratios. For example, a N/Si ratio of 1/5 for the LPCVD process will yield a sin-SiN layer with a conductivity of approximately 4 x $10^{-10}$ (Ω-cm)$^{-1}$, over two orders of magnitude lower than that associated with the same ratio in the plasma process. A 1/1 N/Si ratio in the LPCVD process results in the formation of a sin-SiN layer with a conductivity of approximately 5 x $10^{-19}$ (Ω-cm)$^{-1}$. It is to be understood that various other values of conductivity may be obtained, depending upon the deposition process, applied field, ambient temperature, and other condition. The two plots of FIG. 6 are meant to be exemplary only, teaching in principle that the conductivity of the sin-SiN passivation layer of the present invention may be modified to provide the value desired by the user.

In the formation of a specific device, there may exist upper and lower limits on the conductivity of a sin-SiN resistive layer. The upper limit on conductivity can be dictated by the leakage requirements of the device at maximum operating voltage, minimum metal-to-metal spacing, and metal-to-field shield area ratio. The lower limit may be determined by the minimum dielectric relaxation time of the field shield, where the dielectric relaxation time ($\tau$) is given by:

$$\tau = \epsilon\rho/4\pi \qquad (1)$$

where $\rho$ is the resistivity of the film and $\epsilon$ is the dielectric constant of the material. As long as $\tau$ is less than or equal to the the mobility of the ions causing the device stability, the ions will be neutralized by the resistive field shield. For the sin-SiN film of the present invention, the dielectric constant $\epsilon$ is approximately 8. For a conventional relaxation time $\tau$ of 100 seconds, the lower limit on conductivity (the inverse of the resistivity $\rho$ from equation (1)) will be approximately 5 x $10^{-13}$ (Ω-cm)$^{-1}$.

## *Example*

A sin-SiN resistive field shield was deposited onto a device in a hot wall horizontal tube plasma reactor operated at 440kHz, 200 watts rf-power, and 360° C. The gases used were $NH_3$ and $SiH_4$. The total pressure was 2 torr, and the total gas flow was kept at 1200 SCCM. The $NH_3/SiH_4$ ratio was varied from 5/1 to 1/2. The films were deposited on aluminium-coated 100mm oxidized (1 µm $SiO_2$) silicon wafers. The aluminium thickness was 1.5 µm and the sin-SiN thickness was 1.2 µm. After the sin-SiN films were deposited, the wafers were annealed at 450° C and 500° C in nitrogen for 48 hours.

The matrix of gas flow rates and deposition times were used are given below in Table I.

### TABLE I

### Deposition Conditions for the Plasma Deposited SinSiN Films

| Sample | $NH_3$ | $SiH_4$ | $NH_3/SiH_4$ | Dep.time |
|---|---|---|---|---|

| | | | | |
|---|---|---|---|---|
| | (SCCM | (SCCM) | | (min.) |
| 1 | 1000 | 200 | 5.0 | 55 |
| 2 | 960 | 240 | 4.0 | 40 |
| 3 | 933 | 267 | 3.5 | 25 |
| 4 | 900 | 300 | 3.0 | 25 |
| 5 | 857 | 343 | 2.5 | 25 |
| 6 | 800 | 400 | 2.0 | 25 |
| 7 | 600 | 600 | 1.0 | 30 |
| 8 | 400 | 800 | 0.5 | 30 |

Table II contains the average thickness, refractive index, deposition rate, film stress and N/Si ratio for the various gas flow ratios.

TABLE II

| Stoichiometry, Refractive Index, Thickness, Deposition Rate and Stress | | | | | |
|---|---|---|---|---|---|
| $NH_3/SiH_4$ | N/Si | RI | Thickness | Dep.Rate | Stress |
| | | | (µm) | (nm.min) | ($10^{9}$ dynes/$cm^2$) |
| 5.0 | 1.1 | 2.1 | 1.2 | 22 | -3.0±2.0 |
| 4.0 | 0.69 | 2.35 | 1.1 | 28 | -2.8±2.3 |
| 3.5 | 0.61 | 2.35 | 1.1 | 28 | -2.8±1.5 |
| 3.0 | 0.56 | 2.6 | 1.05 | 42 | -4.0±2.4 |
| 2.5 | 0.47 | 2.8 | 1.1 | 44 | -4.0±2.2 |
| 2.0 | 0.43 | 2.8 | 0.92 | 37 | -4.6±1.5 |
| 1.0 | 0.26 | 3.0 | 0.95 | 32 | -6.0±2.1 |
| 0.5 | 0.15 | 3.1 | 0.90 | 30 | -9.0±3.0 |

>From these results, it is clear that the N/Si flow ratio determines the stoichiometry of these films. This is expected since the only source of nitrogen is $NH_3$ and the only source of silicon is $SiH_4$.

## Claims

1. A semiconductor structure (10) including
a semiconductor substrate (12),
a dielectric insulating layer (24) disposed over the substrate and
a resistive field shield layer (26) for limiting the potential buildup at the substrate caused by electrical charge on the dielectric insulating layer, CHARACTERIZED IN THAT
the resistive field shield layer is of semi-insulating silicon nitride.

2. A semiconductor structure as claimed in claim 1 wherein the resistive field shield layer has a N/Si ratio in the range of 1/1 to 1.5

3. A semiconductor structure (40) as claimed in claim 1 or in claim 2 wherein the resistive field shield layer (42) is interposed between the semiconductor substrate and the dielectric insulating layer (44).

4. A semiconductor structor (30) as claimed in claim 1 or claim 2, wherein the dielectric insulating layer is interposed between the semiconductor substrate and the resistive field shield layer (32).

5. A semiconductor structure (60) as defined in claim 1 or claim 2 wherein the dielectric insulating layer comprises at least two individual layers (62, 66) and the resistive field shield layer (64) is interposed between them.

6. A semiconductor structure as claimed in any of the preceding claims wherein
the semiconductor substrate is of a first conductivity type and comprising:
a first semiconductor region (14) of the first conductivity type formed in a surface portion of the semiconductor substrate,
a second semiconductor region (18) of the second conductivity type opposite to the first type, formed in a surface portion of said semiconductor substrate spaced apart from the first semiconductor region; and
first and second electrode means (20,22) contacting the first and second semiconductor regions, respectively; and wherein
the dielectric insulating layer is disposed over said substrate for electrically isolating said first and second semiconductor regions.

FIG.1

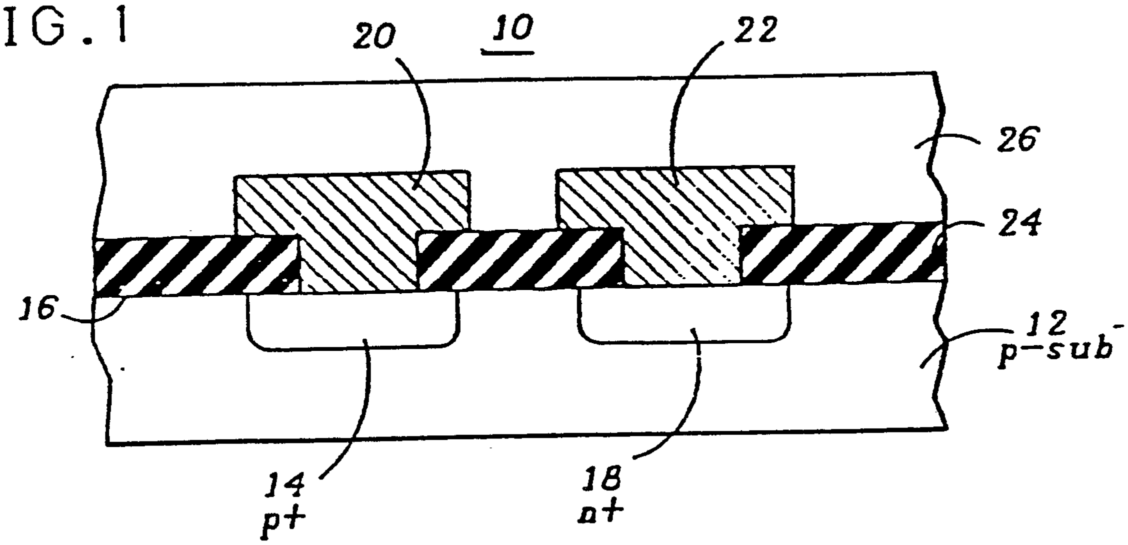


FIG.2

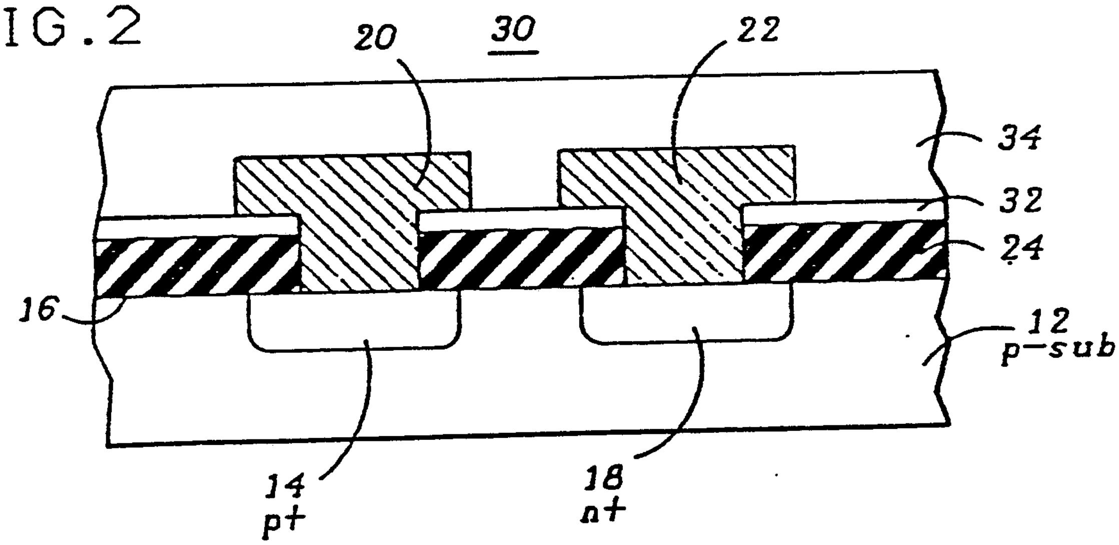


FIG.3

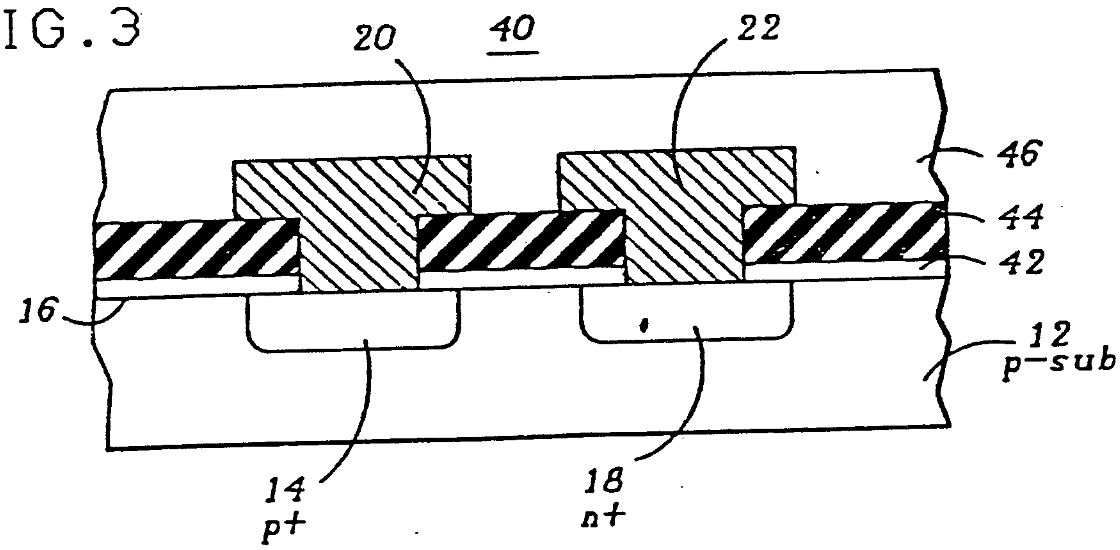

FIG.4

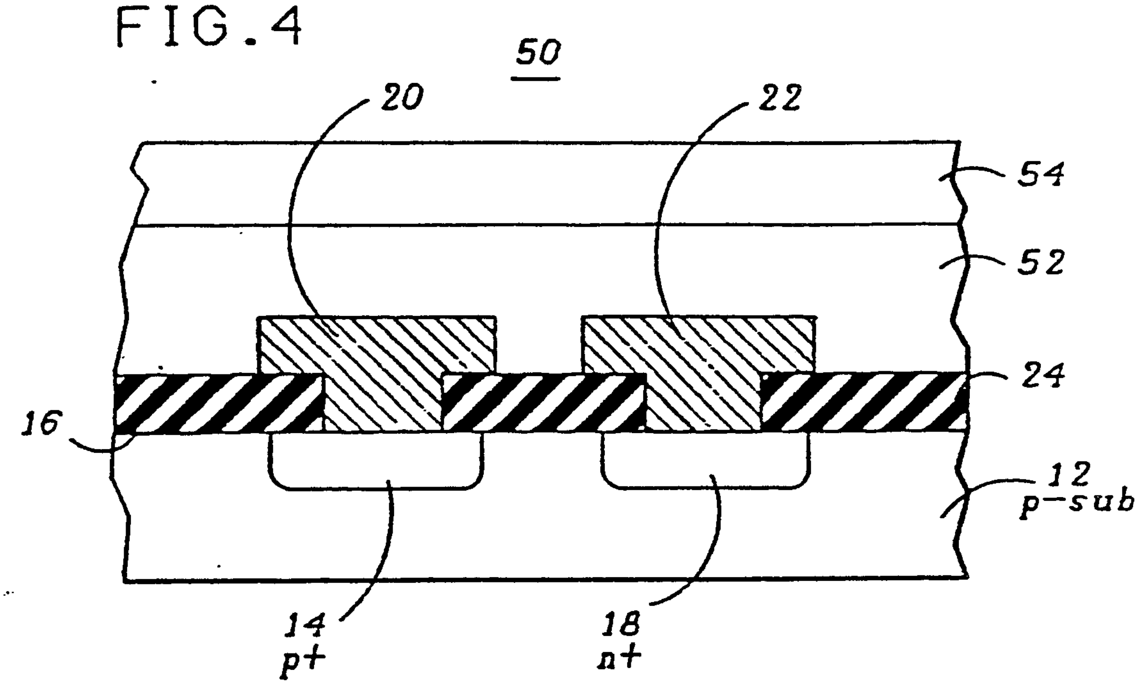
50
20
22
54
52
24
16
12
p-sub
14
p+
18
n+

FIG.5

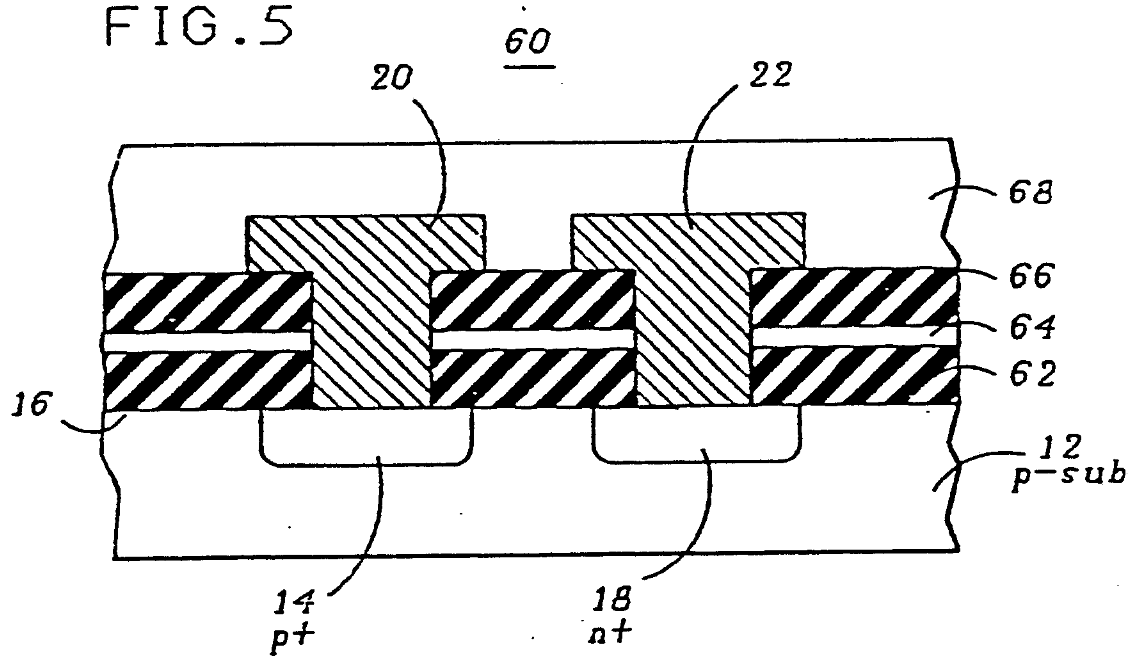
60
20
22
68
66
64
62
16
12
p-sub
14
p+
18
n+

FIG.6

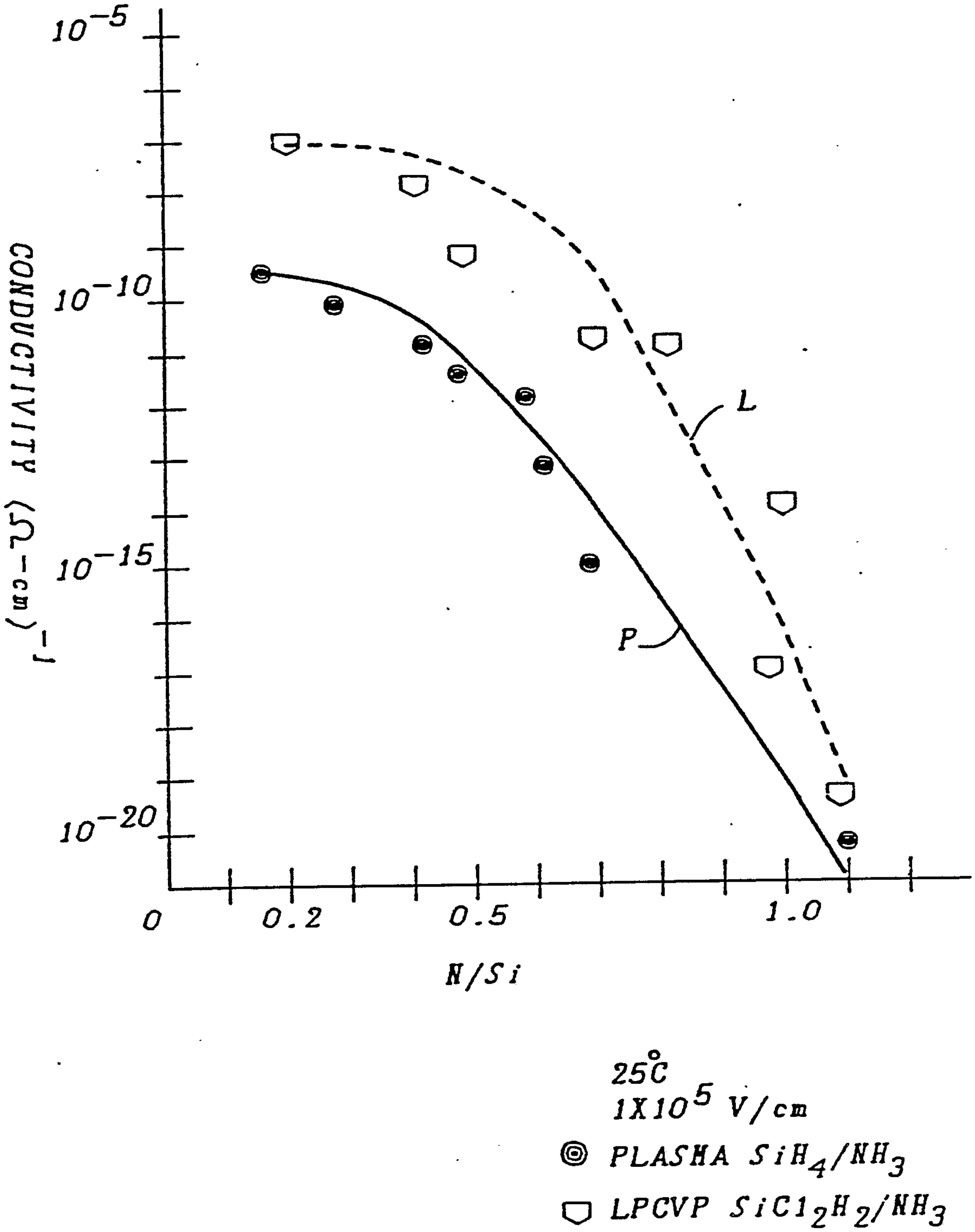
$10^{-5}$
$10^{-10}$
$10^{-15}$
$10^{-20}$
CONDUCTIVITY $(\Omega\text{-cm})^{-1}$
0
0.2
0.5
1.0
N/Si
L
P
25°C
$1X10^5$ V/cm
PLASMA $SiH_4/NH_3$
LPCVP $SiCl_2H_2/NH_3$

European Patent Office

# EUROPEAN SEARCH REPORT

Application Number

EP 88 30 9483

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | JOURNAL OF APPLIED PHYSICS vol. 57 (1985) January, no. 2, pages 426-431, Woodbury, New York, USA; S. FUJITA et al.: "Electricalproperties of silicon nitride films plasma-deposited from SiF4, N2, and H2 source gases " * page 427, column 2, paragraph III, page 428, column 1, figures 4,5 * --- | 1,2 | H 01 L 29/06 |
| A | EP-A-0 146 232 (FUJITSU) * page 5, lines 23-35; page 6; page 9, lines 13-16; page 11, lines 27-35; page 12, lines 1-18 * --- | 1 | |
| A | EXTENDED ABSTRACTS vol. 86-2, (1986) October 19-24, pages 574 - 575, Princeton, New York, USA; L. DOTHANH et al.: "Electrical properties of thin LPCVD Si3N4 films on mono- and polycrystalline silicon" * whole document * --- | 1,2 | TECHNICAL FIELDS SEARCHED (Int. Cl.4) |
| A | EP-A-0 181 002 (HITACHI) * figures; abstract; claims * --- | 3-6 | H 01 L 29/06<br>H 01 L 21/31<br>H 01 L 21/318 |
| D,A | WO-A-8 503 167 (ATT) * abstract, figures, claim 1 * ----- | 3-6 | |

The present search report has been drawn up for all claims

| Place of search | Date of completion of the search | Examiner |
|---|---|---|
| BERLIN | 06-01-1989 | JUHL A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document